# EUROPEAN PATENT APPLICATION

(11) **EP 4 513 571 A1**
(43) Date of publication of application: **26.02.2025**
(21) Application number: 23854179.1
(22) Date of filing: 20.07.2023
(51) Int. Cl.: H01L 29/739, H01L 21/265, H01L 21/331

(54) **IGBT DEVICE HAVING REVERSE CONDUCTION CHARACTERISTICS AND PREPARATION METHOD THEREFOR**

(30) Priority: 15.08.2022 CN 202210973962
(71) Applicant: Chongqing Alpha and Omega Semiconductor Limited, Chongqing 400700 (CN)
(72) Inventor: QIN, Xiaofeng, Chongqing 400700 (CN); SHI, Liang, Chongqing 400700 (CN); HU, Wei, Chongqing 400700 (CN)
(74) Representative: Zaboliene, Reda
(86) International application number: PCT/CN2023/108424
(87) International publication number: WO 2024/037274

(57) **Abstract**

An IGBT device having reverse conduction characteristics and a preparation method therefor are provided. The preparation method includes steps A-E. The step A includes preparing epitaxial layers. Specifically, the step A includes providing a semiconductor substrate, forming a first epitaxial layer on the semiconductor substrate, preparing reverse conductive regions in the first epitaxial layer, and forming a second epitaxial layer on the first epitaxial layer. The step B includes preparing a front surface structure. The step C includes preparing a front surface MOSFET structure having high-density trenches. The step D includes preparing a circuit link layer and a passivation layer. The step E includes preparing a back surface of the IGBT device. In the preparation method, no backside photoetching process is required, which saves costs and reduces a risk of breakage of a wafer. The front surface structure defines high-density trenches, which reduce a warpage degree of the wafer.

## Description

### TECHNICAL FIELD

The present disclosure relates to a field of semiconductor device manufacturing, and in particular to an insulated gate bipolar transistor (IGBT) device having reverse conduction characteristics and a preparation method therefor.

### BACKGROUND

A backside electric field cutoff layer of a conventional IGBT device is generally obtained by performing high-energy ion implantation and performing thermal annealing or laser annealing. For instance, when an implanted element is phosphorus or arsenic and an implantation depth thereof is 2-3um, after laser annealing, the backside electric field cutoff layer having a depth of 3-6um and a concentration of 1e16-1e17/ is obtained. When using light ions such as protons and helium for the ion implantation and an implantation depth thereof is 2-40um, after thermal annealing, the backside electric field cutoff layer having a depth of 3-40um and a concentration of e16-1e17/ is obtained. However, cost of a machine to perform such high-energy ion implantation is high, and requirements for the thermal annealing are high. It is necessary to increase an activation rate as much as possible while ensuring a low activation temperature.

Further, a conventional IGBT having reverse conduction characteristics device is generally prepared by using a dedicated wafer backside photoetching machine. After spin-coating photoresist on a substrate, exposure and development are performed, and then the ion implantation is performed to implant impurities including a trivalent element (to obtain a P-type IGBT device accordingly) or pentavalent elements (to obtain an N-type IGBT device accordingly) on a back surface of the substrate. The impurities are thermally activated to form the IGBT device. However, cost of the dedicated wafer backside photoetching machine is high. Even worse, when performing more complex backside processes on the substrate, there is a high risk of breakage and warpage of a wafer.

### SUMMARY

In order to solve defects in the prior art, the present disclosure provides a preparation method of an insulated gate bipolar transistor (IGBT) device having reverse conduction characteristics.

The preparation method comprises steps A-E. The step A comprises preparing epitaxial layers. Specifically, the step A comprises providing a semiconductor substrate, forming a first epitaxial layer on a surface of the semiconductor substrate, preparing reverse conductive regions in the first epitaxial layer, and forming a second epitaxial layer on the first epitaxial layer. The step B comprises preparing a front surface structure. The step C comprises preparing a front surface metal oxide semiconductor field effect transistor (MOSFET) structure having high-density trenches. The step D comprises preparing a circuit link layer and a passivation layer. The step E comprises preparing a back surface of the IGBT device.

The present disclosure further provides an IGBT device having reverse conduction characteristics. The IGBT device is prepared by the preparation method mentioned above.

In summary, compared with the prior art, in the preparation method of the present disclosure, a backside photoetching process is omitted in the preparation method, thus saving costs.

High-energy ion implantation or annealing is not necessary to be performed on a buffer layer of the IGBT device of the present disclosure, which reduces a risk of breakage of a wafer caused by performing the high-energy ion implantation or the annealing.

A depth and element concentration of the buffer layer of the IGBT device are capable of being easily adjusted. Therefore, an efficiency of ion implantation and a transport coefficient of the buffer layer of the IGBT are adjustable. Thus, IGBT devices having different turn-off characteristics are capable of being prepared to meet needs of different application scenarios.

The front surface MOSFET structure of the IGBT device of the present disclosure has the high-density trenches. Without increasing process costs, using different front-side processing technologies, such as implanting enhancement and carrier storage and other technologies, a capacitance composition ratio of the IGBT device of the present disclosure is easily adjusted to meet the needs of different application scenarios.

Scribe line implantation regions of IGBT device of the present disclosure comprise the same trench structures as the main region, which reduces a warpage degree of the wafer and enables a preparation of the IGBT devices with the high-density trenches on the wafer having a larger size.

### BRIEF DESCRIPTION OF DRAWINGS

FIG. 1 is a top-plan schematic diagram of a IGBT device of the present disclosure.
FIG. 2 is a schematic diagram of the IGBT device after a step S1 in a step A of a preparation method of the IGBT device is performed.
FIG. 3 is a schematic diagram of the IGBT device after a step S2 in the step A of the preparation method of the IGBT device is performed.
FIG. 4 is a schematic diagram of the IGBT device after a step S3 in a step B of the preparation method of the IGBT device is performed.
FIG. 5 is a schematic diagram of the IGBT device after a step S4 in the step B of the preparation method of the IGBT device is performed.
FIG. 6 is a schematic diagram of the IGBT device after a step S5 in the step B of the preparation method of the IGBT device is performed.
FIG. 7 is a schematic diagram of the IGBT device after a step S6 in the step B of the preparation method of the IGBT device is performed.
FIG. 8 is a schematic diagram of the IGBT device after a step S7 in a step C of the preparation method of the IGBT device is performed.
FIG. 9 is a schematic diagram of the IGBT device after a step S8 in the step C of the preparation method of the IGBT device is performed.
FIG. 10 is a schematic diagram of the IGBT device after a step S9 in the step C of the preparation method of the IGBT device is performed.
FIG. 11 is a schematic diagram of the IGBT device after a step S10 in the step C of the preparation method of the IGBT device is performed.
FIG. 12 is a schematic diagram of the IGBT device after a step S11 in the step C of the preparation method of the IGBT device is performed.
FIG. 13 is a schematic diagram of the IGBT device after a step S12 in the step C of the preparation method of the IGBT device is performed.
FIG. 14 is a schematic diagram of the IGBT device after a step S13 in the step C of the preparation method of the IGBT device is performed.
FIG. 15 is a schematic diagram of the IGBT device after a step S14 in the step C of the preparation method of the IGBT device is performed.
FIG. 16 is a schematic diagram of the IGBT device after a step S15 in the step C of the preparation method of the IGBT device is performed.
FIG. 17 is a schematic diagram of the IGBT device after a step S16 in the step C of the preparation method of the IGBT device is performed.
FIG. 18 is a schematic diagram of the IGBT device after a step S17 in the step C of the preparation method of the IGBT device is performed.
FIG. 19 is a schematic diagram of the IGBT device after a step S18 in the step C of the preparation method of the IGBT device is performed.
FIG. 20 is a schematic diagram of the IGBT device after a step S19 in a step D of the preparation method of the IGBT device is performed.
FIG. 21 is a schematic diagram of the IGBT device after a step S20 in the step D of the preparation method of the IGBT device is performed.
FIG. 22 is a schematic diagram of the IGBT device after a step S21in the step D of the preparation method of the IGBT device is performed.
FIG. 23 is a schematic diagram of the IGBT device after a step S22 in the step D of the preparation method of the IGBT device is performed.
FIG. 24 is a schematic diagram of the IGBT device after a step S23 in the step D of the preparation method of the IGBT device is performed.
FIG. 25 is a schematic diagram of the IGBT device after a step S24 in a step E of the preparation method of the IGBT device is performed.
FIG. 26 is a schematic diagram of the IGBT device after a step S25 in the step E of the preparation method of the IGBT device is performed.
FIG. 27 is a schematic diagram of the IGBT device after a step S26 in the step E of the preparation method of the IGBT device is performed.
FIG. 28 is a schematic diagram of the IGBT device after a step S27 in the step E of the preparation method of the IGBT device is performed.
FIG. 29 is a cross-sectional schematic diagram of the IGBT device

### DETAILED DESCRIPTION

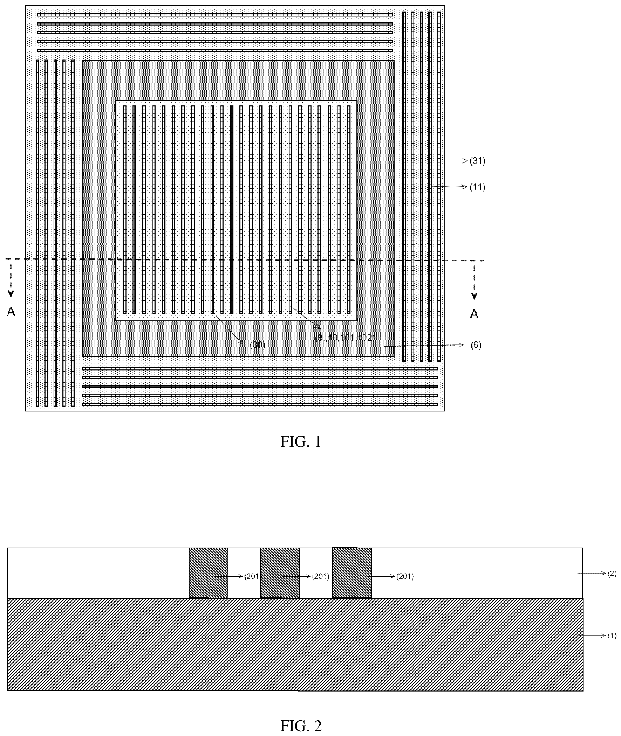

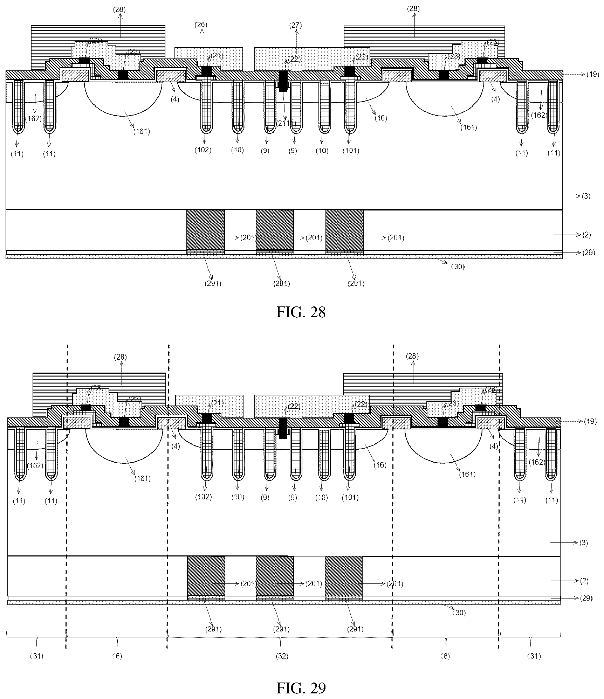

The present disclosure provides a preparation method of a reverse conducting insulated gate bipolar transistor (IGBT) device as shown in FIGS. 1 and 29. The preparation method is configured to reduce a risk of wafer fragmentation and warping during a preparing process of the IGBT device.

The preparation method comprises steps A-E. The step A comprises preparing epitaxial layers. Specifically, the step A comprises providing a semiconductor substrate 1, forming a first epitaxial layer 2 on a surface of the semiconductor substrate 1, preparing reverse conductive regions 201 in the first epitaxial layer2, and forming a second epitaxial layer 3 on the first epitaxial layer 2. The step B comprises preparing a front surface structure. The step C comprises preparing a front surface metal oxide semiconductor field effect transistor (MOSFET) structure having high-density trenches. The step D comprises preparing a circuit link layer and a passivation layer 28. The step E comprises preparing a back surface of the IGBT device.

In one specific embodiment, the step A comprises steps S1-S2.

As shown in FIG. 2, the step S1 comprises growing the first epitaxial layer 2 on an upper surface of the semiconductor substrate 1 by vapor deposition; doping the first epitaxial layer with a first element; spin-coating photoresist on the first epitaxial layer; defining reverse conductive region patterns of a photomask on the photoresist by exposing the photomask under a photoetching machine; performing ion implantation to implant first impurities into the first epitaxial layer 2 to obtain three reverse conductive regions 201; and thermally activating the first impurities to form reverse conductive channels of the IGBT device.

In the embodiment, the first epitaxial layer is served as a buffer layer, and the semiconductor substrate 1 is specifically a silicon substrate 1. The first element is a trivalent element or a pentavalent element. When the first element is the trivalent element (such as boron), the first epitaxial layer is a P-type first epitaxial layer, and when the first element is the pentavalent element (such as arsenic or phosphorus), the first epitaxial layer 2 is an N-type first epitaxial layer.

According to requirements of different application scenarios, a depth of the first epitaxial layer 2 and a concentration of the trivalent element or the pentavalent element doped in the first epitaxial layer 2 are adjustable. The first impurities are the pentavalent element (to form an N-type IGBT device accordingly) or the trivalent element (to form a P-type IGBT device accordingly).

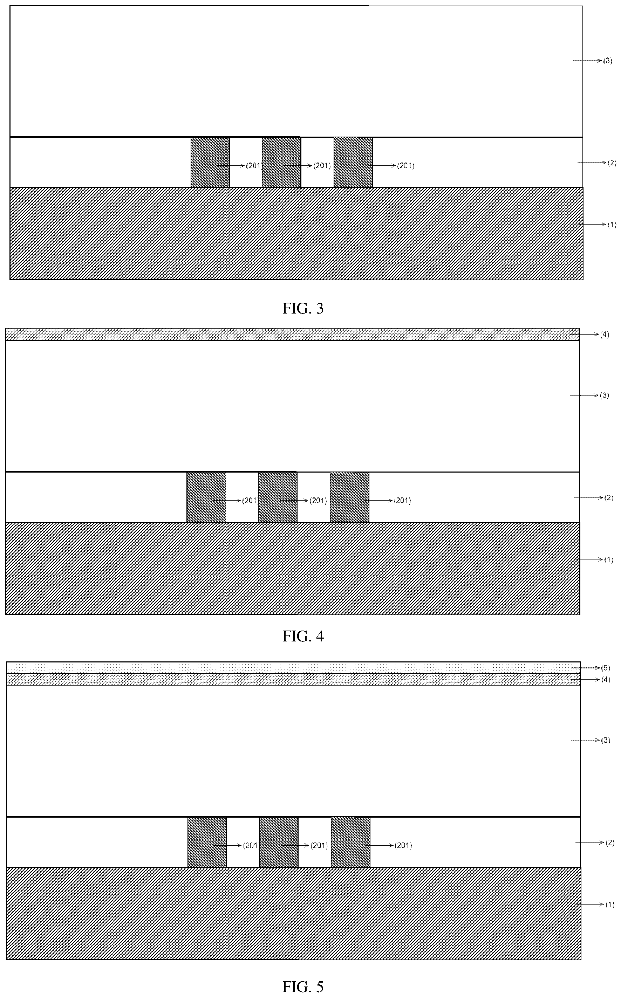

As shown in FIG. 3, the step S2 comprises growing a second epitaxial layer 3 on the first epitaxial layer 2 by the vapor deposition, and doping the second epitaxial layer 3 with a second element. The second epitaxial layer 3 is served as a voltage-resistant layer. The second element is the trivalent element or the pentavalent element. Depending on a polarity of the second epitaxial layer 3, the second epitaxial layer 3 may be a P-type second epitaxial layer 3 (doped with boron) or an N-type second epitaxial layer 3 (doped with arsenic or phosphorus).

The polarity of the second epitaxial layer 3 is the same as a polarity of the first epitaxial layer 2. According to the requirements of different application scenarios, a depth of the second epitaxial layer 3 and a concentration of the trivalent element or the pentavalent element doped in the second epitaxial layer 3 are adjustable.

In one specific embodiment, the step B comprises steps S3-S6.

As shown in FIG. 4, the step S3 comprises depositing silicon dioxide on the second epitaxial layer to obtain a thick oxide layer 4 required by the front surface structure.

As shown in FIG. 5, the step S4 comprises spin-coating a first photoresist layer 5 on the thick oxide layer 4 and defining a circuit pattern of a first mask on the first photoresist layer 5 through exposing the first mask under the photoetching machine.

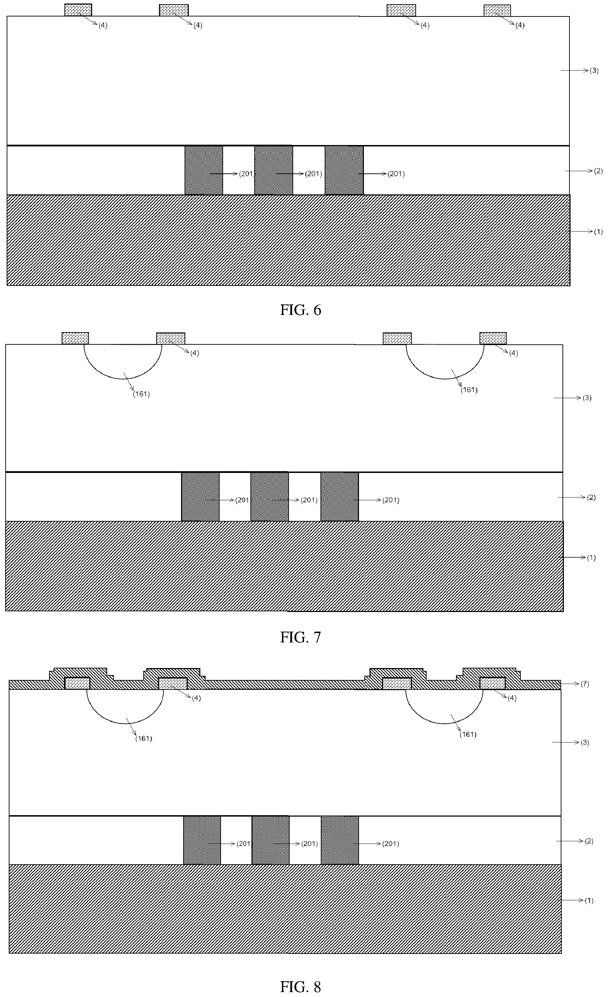

As shown in FIG. 6, the step S5 comprises transferring the circuit pattern to the thick oxide layer 4 by dry etching or wet etching and removing the first photoresist layer 5. Then, two groups of strip-shaped thick oxide layers 4 are obtained on two sides of the second epitaxial layer 3, and each groups of the strip-shaped thick oxide layers 4 comprises two strip-shaped thick oxide layers 4.

As shown in FIG. 7, the step S6 comprises performing ion implantation to implant second impurities on a portion, between the two groups of strip-shaped thick oxide layers 4, of the second epitaxial layer 3 to obtain terminal regions 6 (as shown in FIG. 29); and thermal activating the second impurities to obtain two terminal implantation regions 161. The second impurities comprise the trivalent element (to form an N-type MOSFET structure accordingly) or the pentavalent element (to form a P-type MOSFET structure accordingly). Specifically, the ion implantation is performed on the second epitaxial layer for one or more times to enable the terminal implantation regions 161 to have different withstand voltage values.

In one specific embodiment, the step C comprises steps S7-S18.

As shown in FIG. 8, the step S7 comprises preparing a hard film 7 on an upper surface of the second epitaxial layer 3. The hard film 7 is configured for etching of trenches and is made of silicon dioxide and is prepared by low-temperature chemical vapor deposition or a high-temperature furnace tube process.

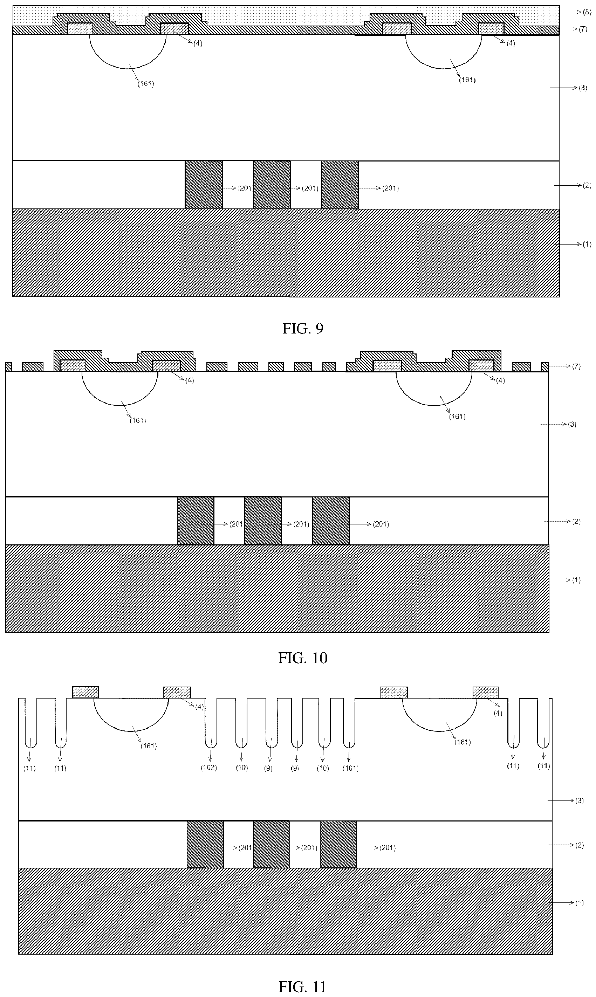

As shown in FIG. 9, the step S8 comprises spin-coating a second photoresist layer 8 on the hard film 7, and defining high-density trench patterns of a second mask on the second photoresist layer 8 through exposing the second mask under the photoetching machine.

As shown in FIG. 10, the step S9 comprises after the high-density trench patterns are formed on the second photoresist layer 8, transferring the high-density trench patterns to the hard film 7 by the dry etching, and removing the second photoresist layer 8.

As shown in FIG. 11, the step S10 comprises after the high-density trench patterns are formed on the hard film 7, performing the dry etching on the second epitaxial layer 3 to form the high-density trenches, and removing the hard film 7.

In one specific embodiment, three kinds of high-density trenches are defined. The high-density trenches comprise two cell active trenches 9, cell pseudo trenches, and scribe line trenches 11. The cell active trenches 9 and the cell pseudo trenches are located in a middle of the second epitaxial layer. The scribe line trenches 11 are respectively located on two sides of the second epitaxial layer 3. The two cell active trenches 9 are configured to realize a conduction effect of actual transistors.

The cell pseudo trenches comprise two cell floating pseudo trenches 10, a cell source pseudo trench 101, and a cell gate pseudo trench 102. The two cell floating pseudo trenches 10 are disposed on two sides of the two cell active trenches 9. The cell source pseudo trench 101 is disposed on one side of a first cell floating pseudo trench away from the cell gate pseudo trench 102. The cell gate pseudo trench 102 is disposed on one side of a second cell floating pseudo trench away from the cell source pseudo trench 101. By choosing to float, connecting to a gate 26 and an emitter 27, the effects of voltage resistance, capacitance adjustment, and a turn-on carrier distribution adjustment are improved. The scribe line trenches 11 are divided into two groups. Two groups of the scribe line trenches11 are respectively located on the two sides of the second epitaxial layer 3. Each of the groups of the scribe line trenches 11 comprises two scribe line trenches 11, which reduce a risk of the warpage of the wafer having a large size.As shown in FIG. 1, trenches (such as the scribe line trenches) defined in the scribe line implantation regions 31 is parallel or perpendicular to trenches defined on a main chip (i.e., the cell active trenches 9 and the cell pseudo trenches), and a density of the trenches defined in the scribe line implantation regions 31 is the same as a density of the trenches defined on the main chip, thereby forming the high-density trenches.

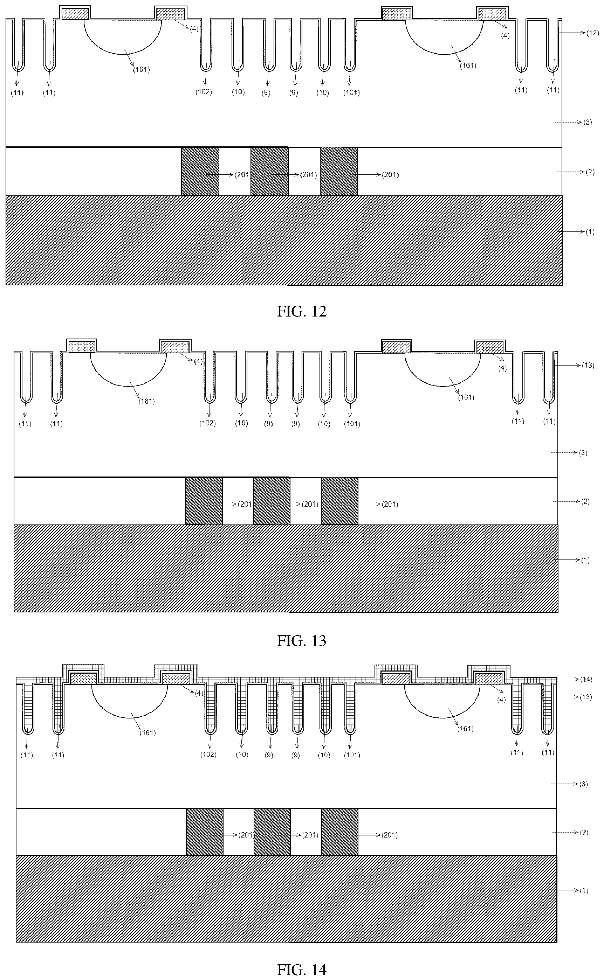

As shown in FIG. 12, the step S11 comprises growing a sacrificial oxide layer 12 on sidewalls of the high-density trenches through a furnace tube thermal oxidation process.

As shown in FIG. 13, the step S12 comprises removing the sacrificial oxide layer 12 by the wet etching and growing a gate oxide layer 13 by the high-temperature furnace tube thermal oxidation process.

As shown in FIG. 14, the step S13 comprises depositing a polysilicon layer 14 on the high-density trenches and the second epitaxial layer 3 through low-pressure chemical vapor deposition.

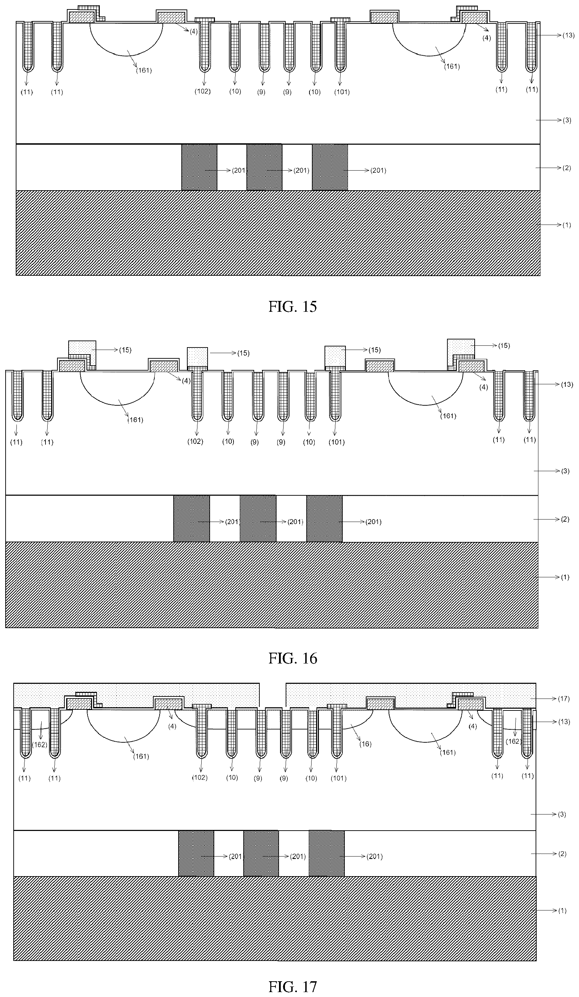

As shown in FIG. 15, the step S14 comprises spin-coating a third photoresist layer 15 on the polysilicon layer 14, defining a trench pattern of a third mask on the third photoresist layer 15 by exposing the third mask under the photoetching machine, and removing the third photoresist layer 15 after transferring the trench pattern onto the polysilicon layer 14 by the dry etching. In particular, the polysilicon layer 14 retained in the step S14 is configured to connect gate 26 to the cell gate pseudo trench 102, and is served as a field plate structure for the terminal regions 6.

As shown in FIG. 16, the step S15 comprises performing the ion implantation to implant third impurities into the second epitaxial layer 3 to obtain a body region 6 and scribe line implantation regions 162; and thermally activating the third impurities. The body region 6 is disposed in the middle of the second epitaxial layer 3 and the scribe line implantation regions 162 are disposed on the two sides of the second epitaxial layer 3. The third impurities comprise the trivalent element (to form the N-type MOSFET structure accordingly) or the pentavalent element (to form the P-type MOSFET structure accordingly).

As shown in FIG. 17, the step S16 comprises spin-coating a fourth photoresist layer 17 on an upper surface of the polysilicon layer 14, defining an active region pattern of a fourth mask on the fourth photoresist layer through exposing the fourth mask under the photoetching machine, and removing the fourth photoresist layer 17.

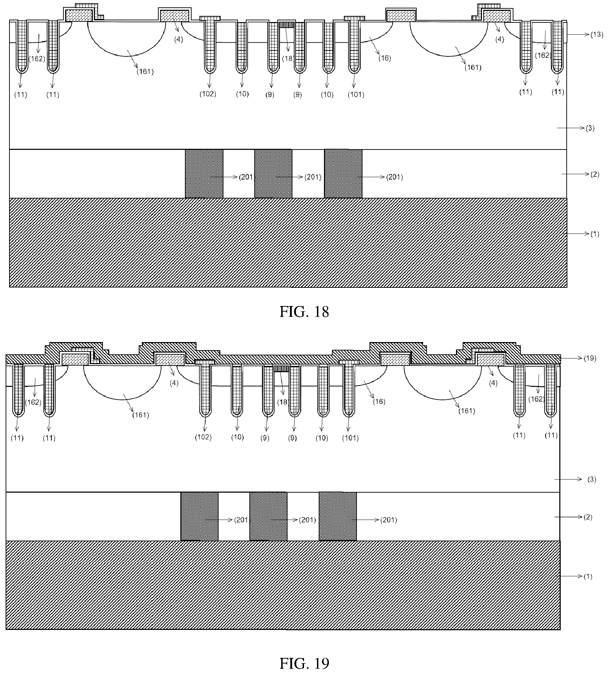

As shown in FIG. 18, the step S17 comprises performing the ion implantation to implant fourth impurities into the second epitaxial layer 3 to obtain the active region 18 and thermally activating the fourth impurities. The active region 18 is disposed between the two cell active trenches 9. The fourth impurities comprise the trivalent element (to form the N-type MOSFET structure accordingly) or the pentavalent element (to form the P-type MOSFET structure accordingly).

As shown in FIG. 19, the step S18 comprises growing a silicon dioxide insulating layer 19 on the upper surface of the polysilicon layer 14.

In one specific embodiment, the step D comprises steps S19-S24.

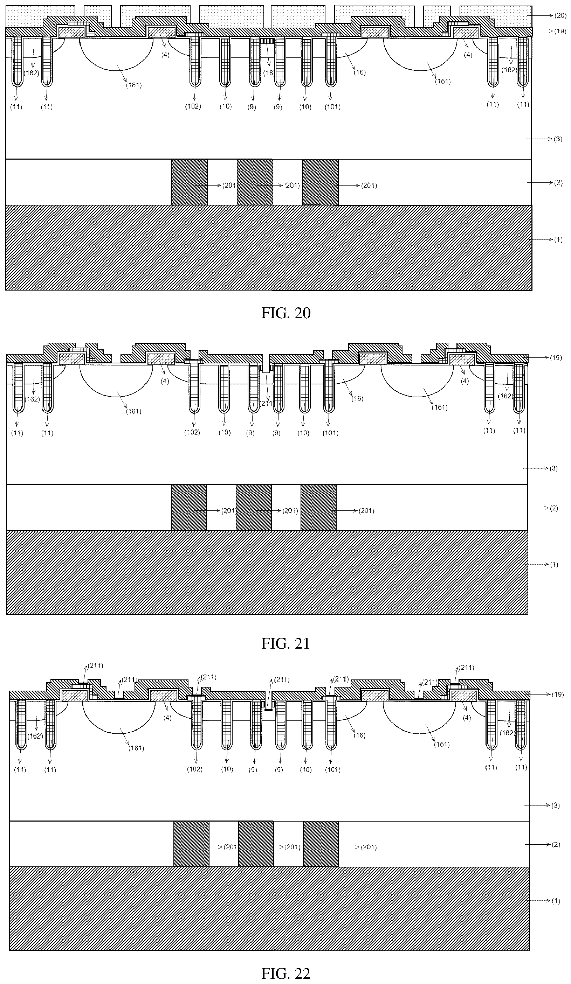

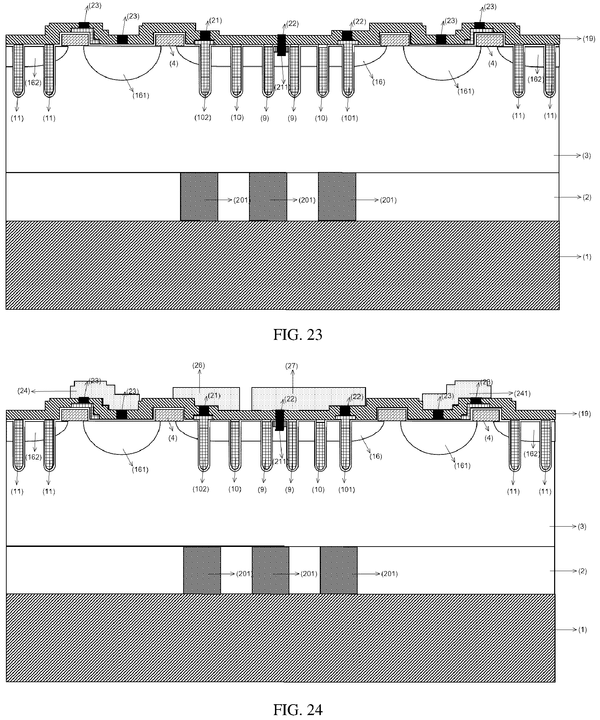

As shown in FIG. 20, the step S19 comprises spin-coating a fifth photoresist layer 20 on a surface of the silicon dioxide insulating layer 19 and defining contact hole patterns of a fifth mask on the fifth photoresist layer through exposing the fifth mask under the photoetching machine. The contact holes that are obtained in FIG. 23 comprise a gate contact hole 21, emitter contact holes 22, and terminal contact holes 23.

As shown in FIG. 21, the step S20 comprises after the contact hole patterns are transferred onto the fifth photoresist layer 20, transferring the contact hole patterns onto the silicon dioxide insulating layer 19 and performing the dry etching to form the gate contact hole, the emitter contact holes, and the terminal contact holes; and removing the fifth photoresist layer 20.

As shown in FIG. 22, the step S21 comprises doping fifth impurities into a bottom portion of the gate contact hole 21, bottom portions of the emitter contact holes 22, and bottom portions of the terminal contact holes 23 by performing the ion implantation, and annealing to activate the fifth impurities to form ohmic contact layers 211.

As shown in FIG. 23, the step S22 comprises depositing metal titanium as a bonding layer by the vapor deposition; forming a silicide by rapid thermal annealing; isotropically depositing metal tungsten, and removing metal tungsten outside the contact holes by the dry etching to form tungsten plugs. The tungsten plugs are disposed in the gate contact hole 21, the emitter contact holes 22, and the terminal contact holes 23.

As shown in FIG. 24, the step S23 comprises depositing an aluminum layer 24 by sputtering; spin-coating a sixth photoresist layer 25; transferring a gate pattern and emitter patterns of a sixth mask onto the sixth photoresist layer through exposing the six mask under the photoetching machine; forming the circuit link layer by the dry etching or dry and wet mixing etching; and removing the sixth photoresist layer25. In particular, the step S23 defines a terminal metal field plate 241 and two electrodes, one of which is the gate 26 and the other is the emitter 27.

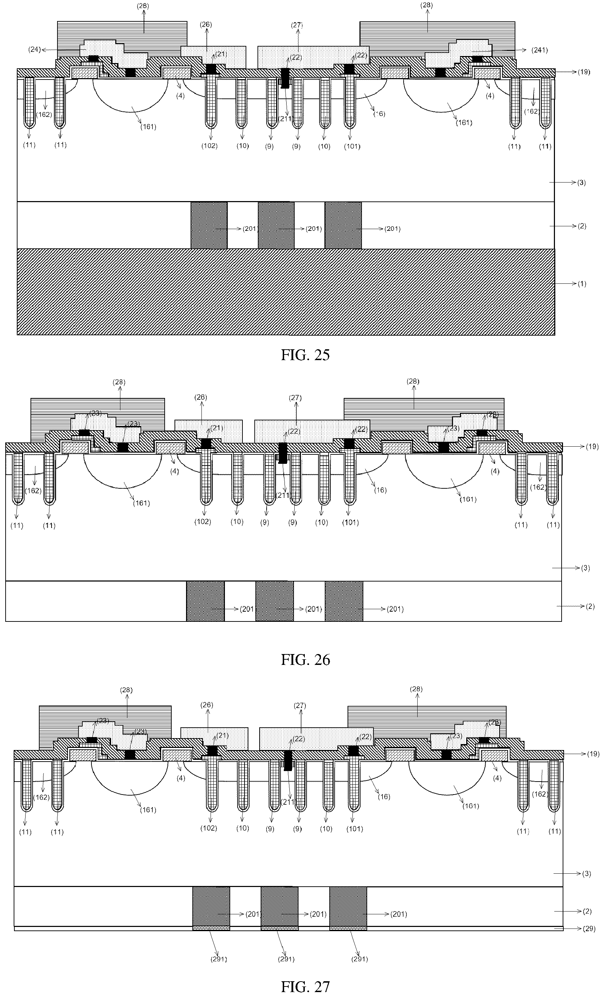

As shown in FIG. 25, the step S24 comprises depositing the passivation layer 28, and exposing bonding pads of the gate 26 and the emitter 27 through a photolithography process and an etching process.

In one specific embodiment, the step E comprises steps S25-S27.

As shown in FIG. 26, the step S25 comprises thinning the IGBT device from a back surface of the semiconductor substrate 1 until the first epitaxial layer 2 is exposed.

As shown in FIG. 27, the step S26 comprises implanting a third element into a back surface of the first epitaxial layer 2 by performing the ion implantation, and activating the third element to form a collector 29 and the reverse conductive channels 291. The third element is the trivalent element (to form the N-type IGBT device) or the pentavalent element (to form the P-type IGBT device). An energy range of the third element is 10 -40k, a dose range of the third element is 1e12-1e13/cm2. The reason why the reverse conductive channels 291 are formed is that a concentration of the third element in the reverse conductive regions 201 is greater than a concentration of the third element in the collector 29. After the third element is activated, a polarity of the reverse conductive channels 291 is opposite to a polarity of the collector 29.

As shown in FIG. 28, the step S27 comprises performing alloy on a back surface of the collector by evaporation or sputtering, and annealing to realize ohmic contact and form a back metal layer 30.

As shown in FIGS. 1 and 29, the embodiment of the present disclosure further provides a IGBT device. The IGBT device comprises terminal regions 6, scribe line implantation regions 31, and a main region 32. The scribe line implantation regions 31 and the main region 32 comprise the high-density trenches. The ion implantation is repeatedly performed on the terminal region 6 for different times according to different voltage level requirements thereof. The ion implantations are repeatedly performed for different times on the scribe line implantation regions 31 according to different width requirements thereof. The ion implantation is repeatedly performed for different times on the main region 32 according to different current specifications thereof.

An area of a 12-inch wafer is 2.25 times that of an 8-inch wafer and 4 times that of a 6-inch wafer. Therefore, under the same production efficiency, a larger-sized wafer at least double a chip output rate. The preparation method of the present disclosure to solve the warpage problem when producing IGBT devices on a large-size wafer. At the same time, when producing the IGBT devices on the large-size wafer through the preparation method of the present disclosure, a dedicated photoetching machine is not required, and the depth of the buffer layer and the concentration of the first element in the buffer layer are easy to adjust. Thus, it is easy to prepare the IGBT devices on the large-size wafer.

## Claims

1. A preparation method of an insulated gate bipolar transistor (IGBT) device having reverse conduction characteristics, comprising:
a step A: preparing epitaxial layers;
a step B: preparing a front surface structure;
a step C: preparing a front surface metal oxide semiconductor field effect transistor (MOSFET) structure having high-density trenches;
a step D: preparing a circuit link layer and a passivation layer (28); and
a step E: preparing a back surface of the IGBT device;
wherein the step A comprises providing a semiconductor substrate, forming a first epitaxial layer (2) on a surface of the semiconductor substrate, preparing reverse conductive regions (201) in the first epitaxial layer (2), and forming a second epitaxial layer (3) on the first epitaxial layer (2).

2. The preparation method of claim 1, wherein the step A comprises:
a step S1: growing the first epitaxial layer (2) on an upper surface of the semiconductor substrate by vapor deposition; doping the first epitaxial layer (2) with a first element; spin-coating photoresist on the first epitaxial layer (2); defining reverse conductive region patterns of a photomask on the photoresist by exposing the photomask under a photoetching machine; performing ion implantation to implant first impurities into the first epitaxial layer (2) to obtain the reverse conductive regions (201); thermally activating the first impurities to form reverse conductive channels (291) of the IGBT device; and
a step S2: growing a second epitaxial layer (3) on the first epitaxial layer (2) by the vapor deposition; doping the second epitaxial layer (3) with a second element;
wherein the first element is a trivalent element or a pentavalent element, the first impurities are the pentavalent element or the trivalent element, and the second element is the trivalent element or the pentavalent element.

3. The preparation method of claim 2, wherein the first epitaxial layer (2) is a buffer layer; the second epitaxial layer (3) is a voltage-resistant layer; a polarity of the second element doped in the second epitaxial layer (3) is the same as a polarity of the first element doped in the first epitaxial layer (2); the trivalent element comprises boron and the pentavalent element comprises arsenic or phosphorus.

4. The preparation method of claim 1, wherein the step B comprises:
a step S3, depositing silicon dioxide on the second epitaxial layer (3) to obtain a thick oxide layer (4);
a step S4: spin-coating a first photoresist layer (5) on the thick oxide layer (4); defining a circuit pattern of a first mask on the first photoresist layer (5) through exposing the first mask under the photoetching machine;
a step S5: transferring the circuit pattern to the thick oxide layer (4) by dry etching or wet etching, and removing the first photoresist layer (5); and
a step S6: performing ion implantation to implant second impurities on the second epitaxial layer (3) to obtain terminal regions (6); thermal activating the second impurities to obtain terminal implantation regions (161); where the ion implantation is performed on the second epitaxial layer (3) for one or more times;
wherein the second impurities comprise a trivalent element or a pentavalent element.

5. The preparation method of claim 4, wherein the step C comprises:
a step S7: preparing a hard film (7) on an upper surface of the second epitaxial layer (3); wherein the hard film (7) is made of silicon dioxide and is prepared by low-temperature chemical vapor deposition or a high-temperature furnace tube process;
a step S8: spin-coating a second photoresist layer (8) on the hard film (7); defining high-density trench patterns of a second mask on the second photoresist layer (8) through exposing the second mask under the photoetching machine;
a step S9: after the high-density trench patterns are formed on the second photoresist layer (8), transferring the high-density trench patterns to the hard film (7) by the dry etching; removing the second photoresist layer (8);
a step S10: after the high-density trench patterns are formed on the hard film (7), performing the dry etching on the second epitaxial layer (3) to form the high-density trenches; removing the hard film (7);
a step S11: growing a sacrificial oxide layer (12) on sidewalls of the high-density trenches through a furnace tube thermal oxidation process;
a step S12: removing the sacrificial oxide layer (12) by the wet etching and growing a gate oxide layer (13) by the high-temperature furnace tube thermal oxidation process;
a step S13: depositing a polysilicon layer (14) on the high-density trenches and the second epitaxial layer (3) through low-pressure chemical vapor deposition;
a step S14: spin-coating a third photoresist layer (15) on the polysilicon layer (14); defining a trench pattern of a third mask on the third photoresist layer (15) by exposing the third mask under the photoetching machine; removing the third photoresist layer (15) after transferring the trench pattern onto the polysilicon layer (14) by the dry etching;
a step S15: performing the ion implantation to implant third impurities into the second epitaxial layer (3) to obtain a body region (16) and scribe line implantation regions (31), and thermally activating the third impurities; wherein the third impurities comprise the trivalent element or the pentavalent element;
a step S16: spin-coating a fourth photoresist layer (17) on an upper surface of the polysilicon layer (14); defining an active region pattern of a fourth mask on the fourth photoresist layer (17) through exposing the fourth mask under the photoetching machine; and removing the fourth photoresist layer (17);
a step S17: performing the ion implantation to implant fourth impurities into the second epitaxial layer (3) to obtain an active region (18) and thermally activating the fourth impurities; wherein the fourth impurities comprise the trivalent element or the pentavalent element; and
a step S18: growing a silicon dioxide insulating layer (19) on the upper surface of the polysilicon layer (14).

6. The preparation method of claim 5, wherein the high-density trenches in the step S10 comprise cell active trenches (9), cell pseudo trenches, and scribe line trenches (11); the cell active trenches (9) and the cell pseudo trenches are located in a middle of the second epitaxial layer (3); the scribe line trenches (11) are respectively located in two sides of the second epitaxial layer (3); the cell pseudo trenches comprise cell floating pseudo trenches (10), a cell source pseudo trench (101), and a cell gate pseudo trench (102).

7. The preparation method of claim 5, wherein the step D comprises:
a step S19: spin-coating a fifth photoresist layer (20) on a surface of the silicon dioxide insulating layer (19) and defining contact hole patterns of a fifth mask on the fifth photoresist layer (20) through exposing the fifth mask under the photoetching machine; wherein the contact hole patterns comprise a gate contact hole pattern, emitter contact hole patterns, and terminal contact hole patterns;
a step S20: after the contact hole patterns are transferred onto the fifth photoresist layer (20), transferring the contact hole patterns onto the silicon dioxide insulating layer and performing the dry etching to form the gate contact hole (21), the emitter contact holes (22), and the terminal contact holes (23); removing the fifth photoresist layer (20);
a step S21: doping fifth impurities into a bottom portion of the gate contact hole (21), bottom portions of the emitter contact holes (22), and bottom portions of the terminal contact holes (23) by performing the ion implantation; and annealing to activate the fifth impurities to form ohmic contact layers (211);
a step S22: depositing metal titanium as a bonding layer by the vapor deposition; forming a silicide by rapid thermal annealing, isotropically depositing metal tungsten; and removing metal tungsten outside the contact holes by the dry etching to form tungsten plugs;
a step S23: depositing a metal layer (24) by sputtering; spin-coating a sixth photoresist layer (25); transferring a gate pattern and emitter patterns of a sixth mask onto the sixth photoresist layer (25) through exposing the six mask under the photoetching machine; forming the circuit link layer by the dry etching or dry and wet mixing etching; and removing the sixth photoresist layer (25); and
a step S24: depositing the passivation layer (28), and exposing bonding pads of the gate (26) and the emitter through a photolithography process and an etching process.

8. The preparation method of claim 1, wherein the step E comprises:
a step S25: thinning the IGBT device from a back surface of the semiconductor substrate until the first epitaxial layer (2) is exposed;
a step S26: implanting a third element into a back surface of the first epitaxial layer (2) by performing the ion implantation; activating the third element to form a collector (29) and the reverse conductive channels (291); wherein the third element is the trivalent element or the pentavalent element; an energy range of the third element is 10 -40k, a dose range of the third element is 1e12-1e13/cm²; after the third element is activated, a polarity of the reverse conductive channels (291) is opposite to a polarity of the collector; and
a step S27: performing alloy on a back surface of the collector (29) by evaporation or sputtering, and annealing to realize ohmic contact and form a back metal layer (30).

9. An IGBT device having reverse conduction characteristics, wherein the IGBT device is prepared by the preparation method of any one of claims 1-8.

10. The IGBT device of claim 9, wherein the IGBT device comprises terminal regions (6), scribe line implantation regions (31), and a main region (32); the scribe line implantation regions (31) and the main region (32) comprise the high-density trenches.
